# EUROPEAN PATENT SPECIFICATION

(11) **EP 4 509 380 B1**
(45) Date of publication and mention of the grant of the patent: **02.12.2026**
(21) Application number: 22937424.4
(22) Date of filing: 13.04.2022
(51) Int. Cl.: B61C 17/00, H05K 7/20, B61C 3/00

(54) **ELECTRONIC APPARATUS**
ELEKTRONISCHES GERÄT
APPAREIL ÉLECTRONIQUE

(43) Date of publication of application: 19.02.2025
(73) Proprietor: MITSUBISHI ELECTRIC CORPORATION, Chiyoda-ku Tokyo 100-8310 (JP)
(72) Inventor: TAKABAYASHI, Hirokazu, Tokyo 100-8310 (JP); MASUYAMA, Takahiro, Tokyo 100-8310 (JP)
(74) Representative: Witte, Weller & Partner Patentanwälte mbB
(86) International application number: PCT/JP2022/017748
(87) International publication number: WO 2023/199445

(56) References cited:
- WO-A1-2021/019642
- WO-A1-2021/199252
- WO-A1-2021/199252
- JP-A- 2000 092 819
- JP-A- 2003 079 164
- JP-A- 2004 088 845
- JP-A- 2016 106 518

## Description

### Technical Field

The present disclosure relates to an electronic device.

### Background Art

An electronic device, such as a power converter, installed on a railway vehicle dissipates heat generated by electronic components with a cooler to passing air created by the traveling vehicle to cool the electronic components. Patent Literature 1 describes an example of such an electronic device. The power converter described in Patent Literature 1 cools electronic components, such as semiconductor elements accommodated inside the housing of the power converter, by causing passing air generated during the travel of the railway vehicles to flow between the coolers.

Patent Literature 2, according to its abstract, relates to a power conversion device comprising: a case disposed on a roof of a vehicle; a heat-receiving block; and at least one heat pipe. The case houses an electronic component and has an opening in an upper section thereof in the vertical direction. The electronic component is attached to a first main surface being one main surface of the heat-receiving block. The heat-receiving block is attached to the case and blocks the opening. At least one heat pipe is attached to a second main surface being the other main surface of the heat-receiving block, extends in the direction away from the heat-receiving block, and has refrigerant filled therein.

Patent Literature 3, according to its abstract, relates to a power conversion device comprising: converter main circuits that convert AC power to DC power; inverter main circuits that convert DC power converted by the converter main circuits into AC power; and a common cooler that cools first switching elements that constitute the inverter main circuits and second switching elements that constitute the converter main circuits. The first switching elements comprise at least one modularized element unit and constitutes a first module. The second switching elements comprise at least one modularized element unit and constitutes a second module. The first and second modules are mounted on to a first surface being a module mounting surface in a base section of the cooler. The first module is arranged in a first direction on the first surface. At least two second modules are arranged lined up in a second direction orthogonal to the first direction, on the first surface.

Patent Literature 4, according to its abstract, states that a power conversion device comprises: a converter circuit that converts an AC power into a DC power by on-off operations of a plurality of semiconductor elements; an inverter circuit that converts the DC power outputted from the converter into a three-phase AC power by on-off operations of a plurality of semiconductor elements; a first cooling body that mounts the semiconductor elements configuring the converter circuit on one surface and has a plurality of cooling fins on the other surface; a second cooling body that mounts the semiconductor elements configuring the inverter circuit on one surface and has a plurality of cooling fins on the other surface, and that is juxtaposed to the first cooling body; and a heat pipe for thermally coupling the first cooling body and the second cooling body with each other.

### Citation List

### Patent Literature

Patent Literature 1: JP 2017-112690 A
Patent Literature 2: WO 2021/199252 A1
Patent Literature 3: WO 2021/019642 A1
Patent Literature 4: JP 2016 106518 A

### Summary of Invention

### Technical Problem

In the power converter described in Patent Literature 1, semiconductor elements to be cooled are mounted at equal intervals on one main surface of the base. To install the power converter on a roof of a railway vehicle, the vertical length of a cooler at an end of the railway vehicle in the width direction is to be shorter than the vertical length of the cooler at the center of the railway vehicle in the width direction, depending on the vehicle limit of the railway vehicle. This causes the cooler to have lower cooling performance at an end of the railway vehicle in the width direction than at the center of the railway vehicle in the width direction. Thus, when the power converter described in Patent Literature 1 is installed on the roof, the electronic components mounted on the base at the end of the railway vehicle in the width direction are not cooled sufficiently.

Under such circumstances, an objective of the present disclosure is to provide an electronic device with high performance in cooling electronic components.

### Solution to Problem

According to the present disclosure, an electronic device as defined in independent claim 1 is provided. Further embodiments of the claimed invention are defined in the dependent claims. Although the claimed invention is only defined by the claims, the below embodiments, examples, and aspects are present for aiding in understanding the background and advantages of the claimed invention.

### Advantageous Effects of Invention

The electronic device according to the above aspect of the invention has a greater amount of total heat generation of the electronic components in the first central portion than in the first end portions. The heat dissipation members in the second central portion have a larger total surface area than the heat dissipation members in the second end portions. The resultant electronic device thus has high performance in cooling the electronic components.

### Brief Description of Drawings

FIG. 1 is a block diagram of an electronic device according to an embodiment;
FIG. 2 is a diagram of the electronic device according to the embodiment, illustrating example installation on a vehicle;
FIG. 3 is a cross-sectional view of the electronic device according to the embodiment taken along line III-III in FIG. 2 as viewed in the direction indicated by the arrows;
FIG. 4 is a cross-sectional view of the electronic device according to the embodiment taken along line IV-IV in FIG. 3 as viewed in the direction indicated by the arrows;
FIG. 5 is a diagram of electronic components, illustrating an example arrangement on a base in the embodiment;
FIG. 6 is a top view of the base in the embodiment;
FIG. 7 is a cross-sectional view of an electronic device according to a modification of the embodiment;
FIG. 8 is a diagram of the electronic components, illustrating another example arrangement on the base in the embodiment; and
FIG. 9 is a diagram of the electronic components, illustrating another example arrangement on the base in the embodiment.

### Description of Embodiments

An electronic device according to one or more embodiments of the present disclosure is described below in detail with reference to the drawings. Like reference signs denote like or corresponding components in the drawings.

An example of an electronic device is a power converter installable on a railway vehicle to convert alternating current (AC) power supplied from an AC power supply to AC power to be supplied to a load and supply the resulting AC power to the load. An electronic device 1 according to one or more embodiments described below is installed on a roof of a railway vehicle and cools electronic components using passing air as airflow moving in the direction opposite to the travel direction of the railway, and natural convection. The passing air results from the travel of the railway vehicle.

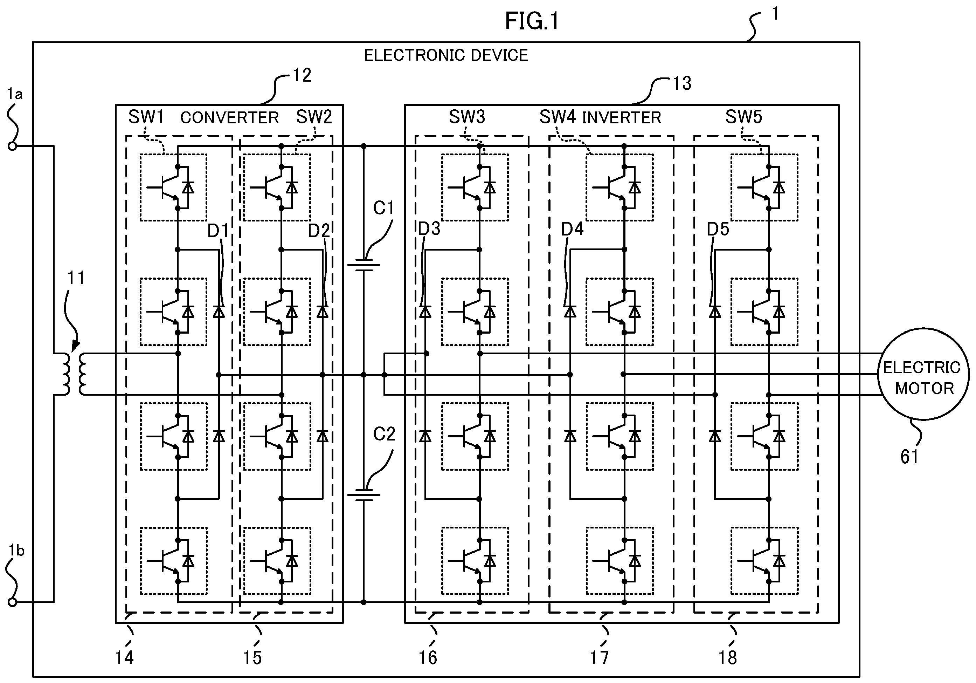

The electronic device 1 illustrated in FIG. 1 is installed on an AC feeding railway vehicle and converts supplied AC power to AC power suitable for an electric motor 61 that is an example of a load, and supplies the resulting AC power to the electric motor 61. The electric motor 61 is, for example, a three-phase induction motor that generates propulsion of the railway vehicle. When the electronic device 1 supplies power to the electric motor 61 during traveling of the railway vehicle, or more specifically, during power running, the electric motor 61 generates propulsion of the railway vehicle.

The components of the electronic device 1 are described below. The electronic device 1 includes an input terminal 1a connected to the power supply and an input terminal 1b grounded. The electronic device 1 further includes a transformer 11 that lowers the voltage of AC power supplied from the power supply connected to the input terminal 1a, a converter 12 that converts the AC power having the voltage lowered by the transformer 11 to DC power, capacitors C1 and C2 that are charged with the DC power output from the converter 12, and an inverter 13 that converts the DC power input through the capacitors C1 and C2 to AC power.

The input terminal 1a is electrically connected to, for example, a current collector that acquires AC power supplied from an electrical substation through a power line. For example, the power line is an overhead power line or a third rail. The current collector is, for example, a pantograph or a collector shoe. The input terminal 1b is short-circuited to rails through, for example, a ground brush, a ground ring, or a wheel, which are not illustrated, and is grounded.

The transformer 11 includes a primary winding having one end connected to the input terminal 1a and the other end connected to the input terminal 1b, and a secondary winding connected to the converter 12. For example, the transformer 11 lowers single-phase AC power with a voltage of 25 kV supplied from the current collector to single-phase AC power with a voltage of 1520 V, and supplies the AC power with the lowered voltage to the converter 12.

The converter 12 includes four switching elements SW1 connected in series and two diodes D1 connected in series. The two diodes D1 are connected in parallel to the central two of the four switching elements SW1. A circuit including the four switching elements SW1 and the two diodes D1 is a U-phase circuit 14.

The converter 12 further includes four switching elements SW2 connected in series and two diodes D2 connected in series. The two diodes D2 are connected in parallel to the central two of the four switching elements SW2. A circuit including the four switching elements SW2 and the two diodes D2 is a V-phase circuit 15.

The four switching elements SW1 and the four switching elements SW2 are connected in parallel to one another. The secondary winding of the transformer 11 has one end connected to the connection point between the two central switching elements SW1, and the other end connected to the connection point between the two central switching elements SW2.

One of the two diodes D1 has the cathode connected to the connection point between the two switching elements SW1 corresponding to an upper arm of the U-phase circuit 14. One of the two diodes D1 has the anode connected to the cathode of the other diode D1. The other diode D1 has the anode connected to the connection point between the two switching elements SW1 corresponding to a lower arm of the U-phase circuit 14.

One of the two diodes D2 has the cathode connected to the connection point between the two switching elements SW2 corresponding to an upper arm of the V-phase circuit 15. One of the two diodes D2 has the anode connected to the cathode of the other diode D2. The other diode D2 has the anode connected to the connection point between the two switching elements SW2 corresponding to a lower arm of the V-phase circuit 15.

The connection point between the two diodes D1 and the connection point between the two diodes D2 are each connected to the connection point between the capacitors C1 and C2.

Each of the switching elements SW1 and SW2 includes, for example, an insulated gate bipolar transistor (IGBT) and a reflux diode having the anode connected to the emitter terminal of the IGBT and the cathode connected to the collector terminal of the IGBT. A gate signal from a non-illustrated controller is provided to the gate terminals of the IGBTs included in the switching elements SW1 and SW2 in the converter 12 to control turning on and off of the IGBTs, in other words, turning on and off of the switching elements SW1 and SW2. The switching operation of each of the switching elements SW1 and SW2 causes the converter 12 to convert AC power supplied from the transformer 11 to DC power.

The capacitors C1 and C2 are connected in series and are chargeable with DC power output from the converter 12.

The inverter 13 includes four switching elements SW3 connected in series and two diodes D3 connected in series. The two diodes D3 are connected in parallel to the central two of the four switching elements SW3. A circuit including the four switching elements SW3 and the two diodes D3 is a U-phase circuit 16.

The inverter 13 further includes four switching elements SW4 connected in series and two diodes D4 connected in series. The two diodes D4 are connected in parallel to the central two of the four switching elements SW4. A circuit including the four switching elements SW4 and the two diodes D4 is a V-phase circuit 17.

The inverter 13 further includes four switching elements SW5 connected in series and two diodes D5 connected in series. The two diodes D5 are connected in parallel to the central two of the four switching elements SW5. A circuit including the four switching elements SW5 and the two diodes D5 is a W-phase circuit 18.

Each of the switching elements SW3, SW4, and SW5 has the same configuration as the switching elements SW1 and SW2. A gate signal from a non-illustrated controller is provided to the gate terminals of the IGBTs included in the switching elements SW3, SW4, and SW5 in the inverter 13 to control turning on and off of the IGBTs, in other words, turning on and off of the switching elements SW3, SW4, and SW5. The switching operation of each of the switching elements SW3, SW4, and SW5 causes the inverter 13 to convert DC power to three-phase AC power and supply the three-phase AC power to the electric motor 61.

The four switching elements SW3, the four switching elements SW4, and the four switching elements SW5 are connected in parallel to one another. The connection point between the two central switching elements SW3, the connection point between the two central switching elements SW4, and the connection point between the two central switching elements SW5 are each connected to the electric motor 61.

One of the two diodes D3 has the cathode connected to the connection point between the two switching elements SW3 corresponding to an upper arm of the U-phase circuit 16. One of the two diodes D3 has the anode connected to the cathode of the other diode D3. The other diode D3 has the anode connected to the connection point between the two switching elements SW3 corresponding to a lower arm of the U-phase circuit 16.

One of the two diodes D4 has the cathode connected to the connection point between the two switching elements SW4 corresponding to an upper arm of the V-phase circuit 17. One of the two diodes D4 has the anode connected to the cathode of the other diode D4. The other diode D4 has the anode connected to the connection point between the two switching elements SW4 corresponding to a lower arm of the V-phase circuit 17.

One of the two diodes D5 has the cathode connected to the connection point between the two switching elements SW5 corresponding to an upper arm of the W-phase circuit 18. One of the two diodes D5 has the anode connected to the cathode of the other diode D5. The other diode D5 has the anode connected to the connection point between the two switching elements SW5 corresponding to a lower arm of the W-phase circuit 18.

The connection point between the two diodes D3, the connection point between the two diodes D4, and the connection point between the two diodes D5 are each connected to the connection point between the capacitors C1 and C2.

While the railway vehicle is traveling, the converter 12 and the inverter 13 are operating. In this state, the switching elements SW1, SW2, SW3, SW4, and SW5 repeatedly turn on and off and thus each perform a switching operation that generates heat. During the operation of the converter 12 and the inverter 13, an electrical current flows through the diodes D1, D2, D3, D4, and D5, causing the diodes D1, D2, D3, D4, and D5 to generate heat. Thus, the electronic device 1 cools the electronic components including the switching elements SW1, SW2, SW3, SW4, and SW5 and the diodes D1, D2, D3, D4, and D5 using passing air when the railway vehicle is traveling, and cools the electronic components including the switching elements SW1, SW2, SW3, SW4 and SW5 and the diodes D1, D2, D3, D4, and D5 using natural convection when the railway vehicle is stopped.

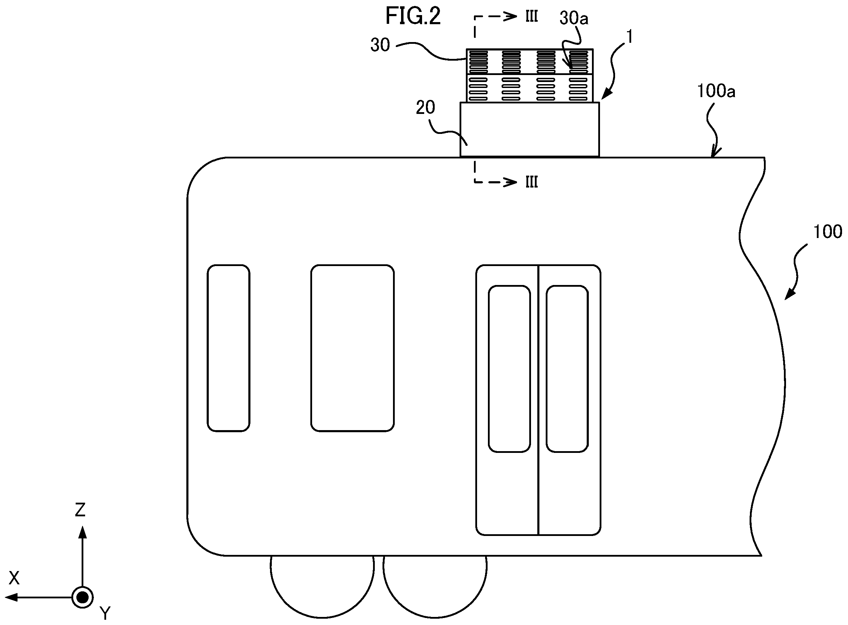

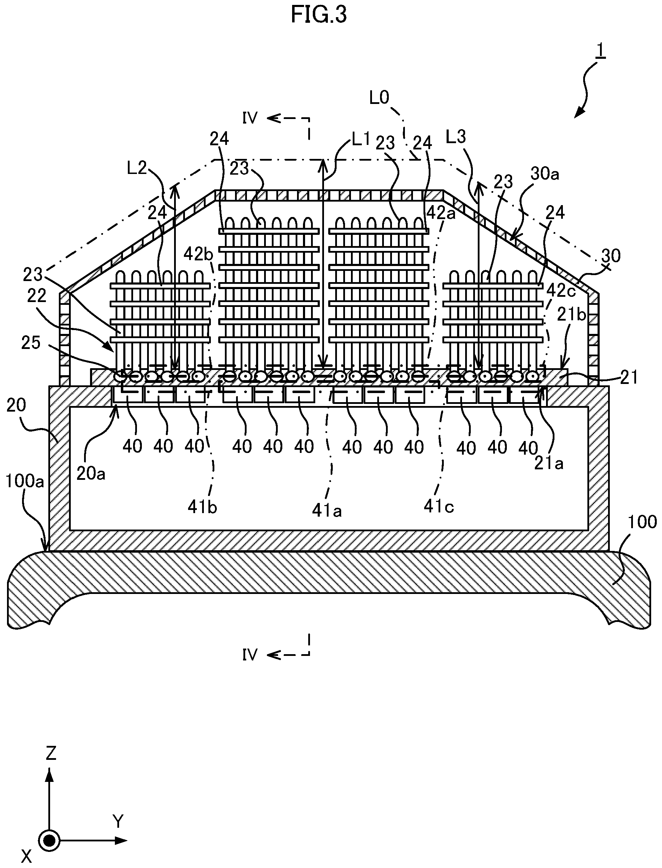

The structure of the electronic device 1 is described in detail below. As illustrated in FIG. 2, the electronic device 1 is installed on a roof 100a of a vehicle 100. As illustrated in FIG. 3 that is a cross-sectional view taken along III-III line in FIG. 2, the electronic device 1 is installed on the roof 100a and includes a housing 20 accommodating electronic components 40 including the switching elements SW1, SW2, SW3, SW4, and SW5, and the diodes D1, D2, D3, D4, and D5. The electronic device 1 further includes a heat-transferable base 21 attached to the housing 20 to cover an opening 20a of the housing 20. The base 21 has a first main surface 21a on which the electronic components 40 are mounted. The electronic device 1 further includes multiple heat dissipation members 22 that are attached to a second main surface 21b of the base 21 to dissipate heat transferred from the electronic components 40 through the base 21 into ambient air.

The electronic device 1 includes, as the multiple heat dissipation members 22, multiple first heat transfer members 23 attached to the second main surface 21b and extending away from the second main surface 21b, and multiple fins 24 attached to the multiple first heat transfer members 23.

To suppress damage to the heat dissipation members 22, or more specifically, to the first heat transfer members 23 and the fins 24, the electronic device 1 preferably further includes a cover 30 attached to the housing 20 to cover the first heat transfer members 23 and the fins 24. The electronic device 1 preferably further includes multiple second heat transfer members 25 that are attached to the base 21 to reduce variations in the performance in cooling the electronic components 40.

In FIGS. 2 and 3, the Z-axis indicates the vertical direction with the vehicle 100 located horizontally. The X-axis indicates the travel direction of the vehicle 100. The Y-axis indicates the width direction of the vehicle 100. The X-axis, Y-axis, and Z-axis are perpendicular to one another. The same applies to the subsequent figures.

The housing 20 is attached to a vertically upper portion of the roof 100a. The housing 20 has rigidity and strength to resist deformation under the maximum expected vibration from the railway vehicle. For example, the housing 20 is formed of metal such as iron or aluminum. The housing 20 has the opening 20a in a vertically upper portion. The housing 20 accommodates the multiple electronic components 40 that generate heat when energized.

The base 21 is attached to the housing 20 with the first main surface 21a covering the opening 20a. In the embodiment, the base 21 is a flat plate of a material with high thermal conductivity, for example, metal such as iron or aluminum, fine ceramics, or graphite, and is attached to the outer surface of the housing 20. The base 21 has the first main surface 21a on which the heat-generating electronic components 40, or more specifically, the switching elements SW1, SW2, SW3, SW4, and SW5 and the diodes D1, D2, D3, D4, and D5 are mounted. The multiple heat dissipation members 22 are attached to the second main surface 21b opposite to the first main surface 21a. With the vehicle 100 located horizontally, the first main surface 21a and the second main surface 21b extend horizontally.

The first heat transfer members 23 included in each heat dissipation member 22 are attached to the second main surface 21b, extend away from the second main surface 21b, and transfer heat away from the second main surface 21b. Each first heat transfer member 23 transfers heat to ambient air and to the fins 24 attached to the first heat transfer member 23.

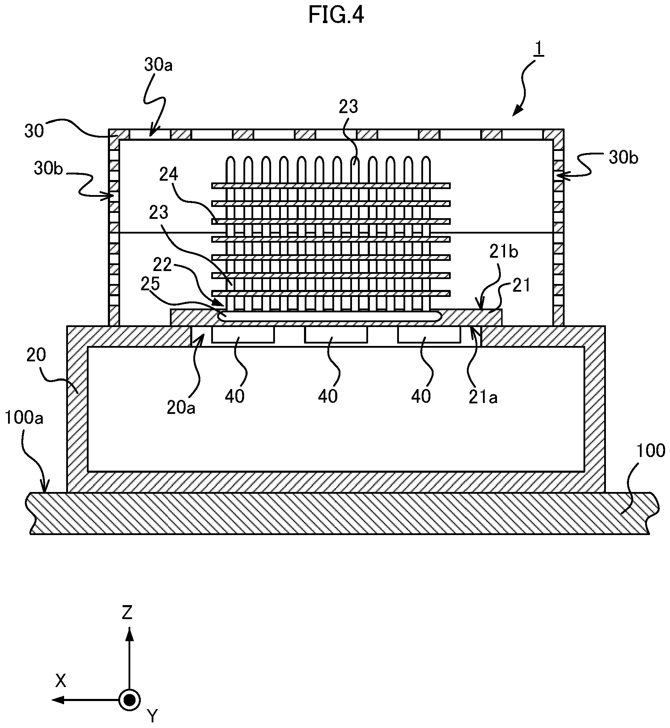

As illustrated in FIG. 3 and FIG. 4 that is a cross-sectional view taken along line IV-IV in FIG. 3 as viewed in the direction indicated by the arrows, the multiple first heat transfer members 23 extending in the Z-axis direction are arranged in the X-axis direction and Y-axis direction. Each first heat transfer member 23 is attached to the second main surface 21b with an attaching method such as welding, or soldering. Each first heat transfer member 23 is a heat pipe of a material with high thermal conductivity, for example, metal such as iron or aluminum.

As illustrated in FIG. 3, the length of the first heat transfer member 23 in the Z-axis direction is set to a length included in a vehicle limit L0 in a cross section perpendicular to the travel direction of the vehicle 100, in other words, the YZ plane. In the YZ plane, the vehicle limit L0 is indicated by multiple line segments. The vehicle limit L0 indicates the maximum dimensions of the vehicle 100. In the embodiment, the length of the first heat transfer member 23 in the Z-axis direction differs depending on the vehicle limit L0. More specifically, the first heat transfer members 23 located at each end in the Y-axis direction are shorter in the Z-axis direction than the first heat transfer members 23 located at the center in the Y-axis direction.

The fins 24 in the heat dissipation members 22 are attached to the multiple first heat transfer members 23 with the main surfaces extending along the second main surface 21b. More specifically, the fins 24 are attached to the multiple first heat transfer members 23, with the first heat transfer members 23 placed through through-holes in the fins 24. The fins 24 attached to the first heat transfer members 23 dissipate heat transferred from the electronic components through the base 21 and the first heat transfer members 23 into ambient air. In the embodiment, each fin 24 is a flat plate of a material with high thermal conductivity, for example, metal such as iron or aluminum, fine ceramics, or graphite. With the vehicle 100 located horizontally, main surfaces of the fins 24 extend horizontally.

To improve the performance in cooling the electronic components 40 when the vehicle 100 is traveling, the main surfaces of the fins 24 is preferably parallel to the X-axis. With passing air generated during the travel of the vehicle 100 flowing in the X-axis direction, the main surfaces of the fins 24 parallel to the X-axis allow heat to be efficiently transferred from the fins 24 to the passing air flowing between the fins 24. Thus, the electronic components 40 can be cooled efficiently.

The multiple second heat transfer members 25 extending in the X-axis direction are arranged in the Y-axis direction. Each second heat transfer member 25 is embedded in the base 21. Each second heat transfer member 25 is a heat pipe of a material with high thermal conductivity, for example, metal such as iron or aluminum. The multiple first heat transfer members 23 are attached and connected to the respective second heat transfer members 25. A coolant in a gas-liquid two-phase state at normal temperature is enclosed in the first heat transfer members 23 and the second heat transfer members 25. An example of the coolant is water.

When the vehicle 100 is traveling, passing air heated with heat transferred from the fins 24 at the front in the travel direction of the vehicle 100 flows rearward in the travel direction of the vehicle 100. Thus, in the electronic device 1, the electronic components 40 located at the rear in the travel direction of the vehicle 100 may be cooled less sufficiently than the electronic components 40 located at the front in the travel direction of the vehicle 100. The second heat transfer members 25 extending in the X-axis direction as described above and the convection of the coolant inside the second heat transfer members 25 cause heat distribution in the X-axis direction, thus reducing variations in cooling the electronic components 40 that are arranged in the X-axis direction.

The cover 30 is attached to the housing 20 to cover the base 21 and the heat dissipation members 22. The cover 30 has multiple vents 30a in a surface extending along the X-axis. The vents 30a allow outside air to flow into the cover 30, and allow air flowing near the heat dissipation members 22 and the fins 24 to flow out of the cover 30. As illustrated in FIG. 4, the cover 30 has multiple vents 30b in surfaces perpendicular to the X-axis. The vents 30b allow outside air to flow into the cover 30, and allow air flowing near the first heat transfer members 23 and the fins 24 to flow out of the cover 30.

Cooling of the electronic components 40 in the electronic device 1 with the above structure is described below. Heat generated by the electronic components 40 is transferred to the coolant through the base 21 and the second heat transfer members 25. The coolant thus vaporizes. The vaporized coolant flows from the second heat transfer members 25 into the first heat transfer members 23 and moves inside the first heat transfer members 23 in the positive Z-axis direction. The coolant transfers heat to ambient air around the heat dissipation members 22 through the first heat transfer members 23 and the fins 24 while moving in the positive Z-axis direction, and is cooled and liquefies. The liquefied coolant moves along the inner walls of the first heat transfer members 23 in the negative Z-axis direction and returns to the second heat transfer members 25. As the coolant circulates while repeatedly vaporizing and liquefying as described above, the heat generated by the electronic components 40 is transferred to ambient air around the heat dissipation members 22, thus cooling the electronic components 40 that are generating heat.

For example, passing air flowing in the negative X-axis direction occurs when the vehicle 100 travels in the positive X-axis direction. The passing air flows inside the cover 30 through the vents 30b illustrated in FIG. 4, passes between the fins 24, and flows out of the cover 30 through the vents 30b. As the passing air passes between the fins 24, heat is transferred from the fins 24 to the passing air to cool the electronic components 40.

When the vehicle 100 is stopped, no passing air occurs. The air inside the cover 30 is heated with the heat transferred from the fins 24, flows along the fins 24, and moves vertically upward between the fins 24. The air moving vertically upward flows out of the cover 30 through the vents 30a in a vertically upper portion of the cover 30 illustrated in FIG. 3. When the air inside the cover 30 flows out through the vents 30a, air outside the cover 30 flows inside the cover 30 through the vents 30a and 30b, as illustrated in FIGS. 3 and 4. Natural convection can thus be used to cool the electronic components 40 also when the vehicle 100 is stopped.

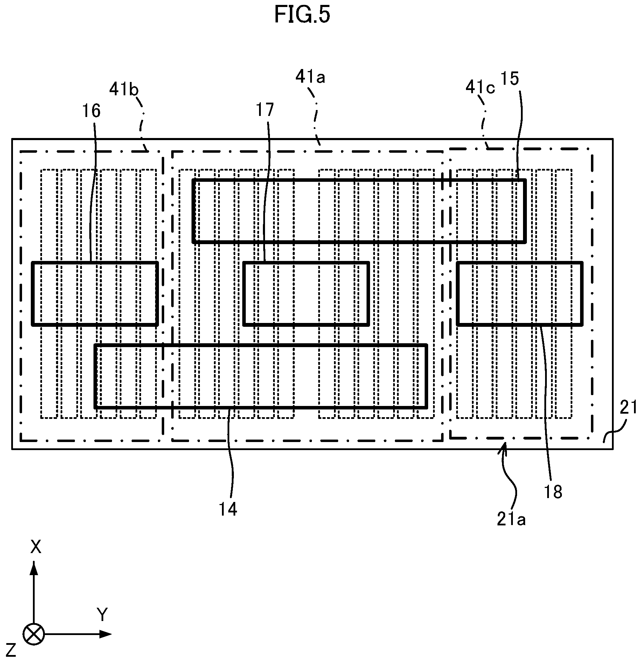

The structure of the electronic device 1 for efficiently cooling the electronic components 40 is described below. As illustrated in FIGS. 3 and 5, the first main surface 21a of the base 21 is divided into a first central portion 41a including the center of the first main surface 21a in the Y-axis direction and extending in the X-axis direction, and first end portions 41b and 41c located with the first central portion 41a between the first end portions 41b and 41c in the Y-axis direction. The first end portions 41b and 41c include the ends of the first main surface 21a in the Y-axis direction and extend in the X-axis direction.

More specifically, the first main surface 21a has an area with the distance to the vehicle limit L0 on the roof greater than a first threshold as the first central portion 41a, and areas with the distance to the vehicle limit L0 less than the first threshold as the first end portions 41b and 41c. The first threshold is the distance from the first main surface 21a to the vehicle limit L0 at a position shifted from the end of the first main surface 21a toward the center of the base 21 in the width direction of the vehicle 100 by one-fourth of the length of the base 21 in the width direction.

In the embodiment, the first central portion 41a has an area substantially equal to the total area of the first end portions 41b and 41c. The areas being substantially equal to each other refers to the areas with the area ratio of 0.95 to 1.05 inclusive.

As illustrated in FIG. 3, the first central portion 41a has a distance L1 from the first main surface 21a to the vehicle limit L0 greater than both a distance L2 from the first main surface 21a to the vehicle limit L0 in the first end portion 41b and a distance L3 from the first main surface 21a to the vehicle limit L0 in the first end portion 41c.

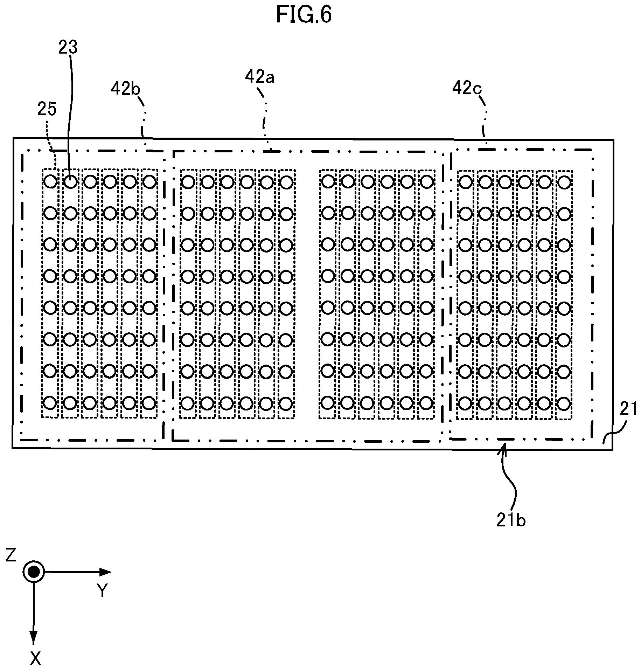

As illustrated in FIGS. 3 and 6, the second main surface 21b of the base 21 is divided into a second central portion 42a including the center of the second main surface 21b in the Y-axis direction and extending in the X-axis direction, and second end portions 42b and 42c located with the second central portion 42a between the second end portions 42b and 42c in the Y-axis direction. The second end portions 42b and 42c include the ends of the second main surface 21b in the Y-axis direction and extend in the X-axis direction. For simplicity, the fins 24 are not illustrated in FIG. 6.

More specifically, the second main surface 21b has an area with the distance to the vehicle limit L0 greater than a second threshold as the second central portion 42a, and areas with the distance to the vehicle limit L0 less than the second threshold as the second end portions 42b and 42c. The second threshold is the distance from the second main surface 21b to the vehicle limit L0 at a position shifted from the end of the second main surface 21b toward the center of the base 21 in the width direction of the vehicle 100 by one-fourth of the length of the base 21 in the width direction.

In the embodiment, the second central portion 42a has an area substantially equal to the total area of the second end portions 42b and 42c. As illustrated in FIG. 3, the second central portion 42a is located opposite to the first central portion 41a with respect to the base 21. Similarly, the second end portions 42b and 42c are located opposite to the respective first end portions 41b and 41c with respect to the base 21. For example, the second central portion 42a has an area substantially equal to the area of the first central portion 41a, and the second end portions 42b and 42c have areas substantially equal to the areas of the respective first end portions 41b and 41c.

The heat dissipation members 22 attached to the second central portion 42a have a larger total surface area than the heat dissipation members 22 attached to the second end portions 42b and 42c. More specifically, the first heat transfer members 23 attached to the second central portions 42a and the fins 24 attached to the first heat transfer members 23 have a larger total surface area than the first heat transfer members 23 attached to the second end portions 42b and 42c and the fins 24 attached to the first heat transfer members 23.

In the embodiment, the first heat transfer members 23 in the second central portion 42a are longer in the Z-axis direction than the first heat transfer members 23 in the second end portions 42b and 42c. More fins 24 are attached to the first heat transfer members 23 in the second central portions 42a than to the first heat transfer members 23 in the second end portions 42b and 42c.

Thus, the heat dissipation members 22 in the second central portion 42a have a larger surface area than the heat dissipation members 22 in the second end portions 42b and 42c. Thus, the heat dissipation members 22 in the second central portion 42a has higher cooling performance than the heat dissipation members 22 in the second end portions 42b and 42c.

The electronic components 40 mounted in the first central portion 41a are arranged to have a greater amount of total heat generation than the electronic components 40 mounted in the first end portions 41b and 41c. FIG. 5 illustrates an example arrangement of the electronic components 40, or more specifically, the U-phase circuit 14, the V-phase circuit 15, the U-phase circuit 16, the V-phase circuit 17, and the W-phase circuit 18.

More specifically, the components of the U-phase circuit 14 and the V-phase circuit 15 in the converter 12 are mounted in the first central portion 41a to have the components of the V-phase circuit 17 in the inverter 13 between the components of the U-phase circuit 14 and the V-phase circuit 15 in the X-axis direction. Some components of the U-phase circuit 14 are mounted adjacent to some components of the U-phase circuit 16 in the X-axis direction on the first main surface 21a in the first end portion 41b. Some components of the V-phase circuit 15 are mounted adj acent to some components of the W-phase circuit 18 in the X-axis direction in the first end portion 41c.

In the above arrangement, more electronic components 40 are mounted in the first central portion 41a than in the first end portions 41b and 41c. Thus, the electronic components 40 mounted in the first central portion 41a has a greater amount of total heat generation than the electronic components 40 mounted in the first end portions 41b and 41c.

An electrical current constantly flows in the two central switching elements SW1 in the U-phase circuit 14 when the converter 12 is operating. Thus, the two central switching elements SW1 in the U-phase circuit 14 are preferably mounted in the first central portion 41a. Similarly, an electrical current constantly flows in the two central switching elements SW2 in the V-phase circuit 15 when the converter 12 is operating. Thus, the two central switching elements SW2 in the V-phase circuit 15 are preferably mounted in the first central portion 41a.

The electronic components 40 mounted in the first central portion 41a corresponding to the second central portion 42a with the heat dissipation members 22 having high cooling performance generate more heat to maximize the cooling performance of the heat dissipation members 22 to cool the electronic components 40.

The electronic components 40 may generate more heat at different times. When the electronic components 40 start generating more heat at different times, more heat may be transferred to some first heat transfer members 23 and less heat may be transferred to other first heat transfer members 23. The multiple electronic components 40 may include multiple first electronic components, and multiple second electronic components that generate more heat at different times from any of the first electronic components. For example, the multiple first electronic components include the components of the U-phase circuit 14 and the V-phase circuit 15 in the converter 12, or more specifically, the switching elements SW1 and SW2 and the diodes D1 and D2. The second electronic components include the components of the U-phase circuit 16, the V-phase circuit 17, and the W-phase circuit 18 in the inverter 13, or more specifically, the switching elements SW3, SW4, and SW5 and the diodes D3, D4, and D5.

The components of the converter 12 and the components of the inverter 13 start generating more heat at different times. More specifically, with the electric motor 61 under constant torque control from when the vehicle 100 starts accelerating to when the vehicle 100 reaches a threshold speed, the power to be used increases in proportion to the speed of the vehicle 100. Thus, the loss in the converter 12 gradually increases as the speed of the vehicle 100 increases. When the vehicle 100 reaches the threshold speed, the electric motor 61 is under constant power control. The power to be used is thus substantially constant independently of the speed. Thus, the loss in the converter 12 reaches the maximum when the speed of the vehicle 100 reaches the threshold speed and is substantially constant at the maximum at the speed of the vehicle 100 higher than or equal to the threshold speed. The threshold speed is, for example, 30 to 50% inclusive of the maximum speed of the vehicle 100.

When the electric motor 61 is under constant torque control, the electrical current through the electric motor 61 is at the maximum. Until the vehicle 100 reaches the threshold speed, the electric motor 61 undergoes asynchronous pulse width modulation (PMW) control with the switching frequency of the inverter 13 of about 1 kHz, for example, independently of the rotational speed of the electric motor 61. This increases the switching loss of the inverter 13. When the vehicle 100 reaches the threshold speed, the electric motor 61 undergoes PWM control in a synchronous pulse mode based on the switching frequency corresponding to the rotational speed of the electric motor 61. The switching loss of the inverter 13 is thus smaller than during asynchronous PWM control.

In other words, the components of the inverter 13 start generating more heat when the vehicle 100 is at low speed, and the components of the converter 12 start generating more heat when the vehicle 100 is at high speed. As illustrated in FIG. 5, the U-phase circuit 14 and the V-phase circuit 15 in the converter 12 are mounted in the first central portion 41a to have the V-phase circuit 17 in the inverter 13 between the U-phase circuit 14 and the V-phase circuit 15 in the X-axis direction. The second heat transfer members 25 further extend in the X-axis direction on the base 21. Thus, although the converter 12 and the inverter 13 start generating more heat at different times, heat is diffused in the base 21 in the X-axis direction and then transferred to each of the first heat transfer members 23 arranged in the X-axis direction, thus efficiently cooling the electronic components 40.

In the electronic device 1 according to the invention, the electronic components 40 mounted in the first central portion 41a have a greater amount of total heat generation than the electronic components 40 mounted in the first end portions 41b and 41c. The heat dissipation members 22 attached to the second central portion 42a have a larger total surface area than the heat dissipation members 22 attached to the second end portions 42b and 42c. In other words, the electronic components 40 that generate more heat are at positions corresponding to the heat dissipation members 22 with higher cooling performance. The electronic device 1 can thus have high performance in cooling the electronic components 40.

The improved performance in cooling the electronic components 40 reduces the temperature rise in the electronic components 40, extends the service life of the electronic components 40, and reduces the failure rate of the electronic components 40.

With the electronic components 40 that start generating more heat at different times arranged in the X-axis direction and the second heat transfer members 25 extending in the X-axis direction, heat is transferred to the first heat transfer members 23 arranged in the X-axis direction. This structure efficiently cools the electronic components 40.

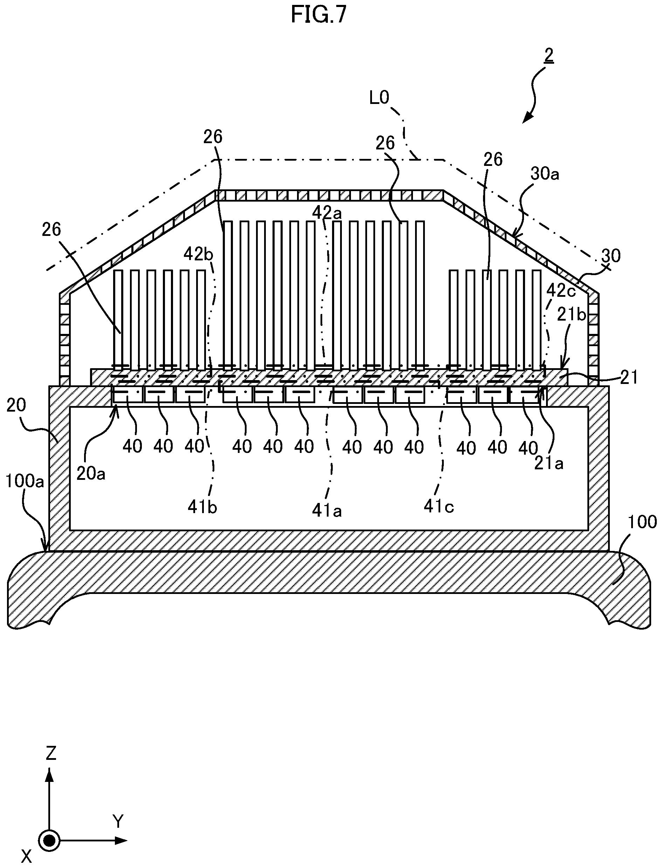

The present disclosure is not limited to the above embodiments. The heat dissipation members 22 may have any structure that can dissipate heat transferred from the electronic components 40 through the base 21 into ambient air. FIG. 7 illustrates an example of an electronic device 2 that includes heat dissipation members with a different structure. The electronic device 2 has the same circuit configuration as the electronic device 1. The electronic device 2 illustrated in FIG. 7 includes multiple fins 26 as the heat dissipation members. Each fin 26 is attached to the second main surface 21b of the base 21 with an attaching method such as adhesive bonding, welding, or brazing. Each fin 26 is a flat plate of a material with high thermal conductivity, for example, metal such as iron or aluminum, fine ceramics, or graphite.

The fins 26 attached to the second central portion 42a are longer than the fins 26 attached to the second end portions 42b and 42c in the Z-axis direction. When each fin 26 has the same length in the X-axis direction, the fin 26 attached to the second central portion 42a has a larger surface area than the fin 26 attached to the second end portion 42b or 42c. The fins 26 in the second central portion 42a thus have higher cooling performance than the fins 26 in the second end portions 42b and 42c.

As another example, each first heat transfer member 23 may be a rod-like member of a material with high thermal conductivity, for example, metal such as iron or aluminum, fine ceramics, or graphite. In this case, each second heat transfer member 25 may be a rod-like member of a material with high thermal conductivity, for example, metal such as iron or aluminum, fine ceramics, or graphite. Each first heat transfer member 23 may be attached to the corresponding second heat transfer member 25 with an attaching method such as adhesive bonding, welding, or brazing.

The shape of each first heat transfer member 23 is not limited to the above example. In an example, each first heat transfer member 23 may be a U- or L-shaped heat pipe partially received in a groove on the second main surface 21b.

The first central portion 41a and the first end portions 41b and 41c may not be the portions divided in the manner in the above example. In a further embodiment,, the first threshold are defined based on the distance from the first main surface 21a to the vehicle limit L0 at the center in the width direction and the distance from the first main surface 21a to the vehicle limit L0 at the end in the width direction. More specifically, the first threshold is defined as the average of the distance from the first main surface 21a to the vehicle limit L0 at the center in the width direction and the distance from the first main surface 21a to the vehicle limit L0 at the end in the width direction.

The second central portion 42a and the second end portions 42b and 42c may not be the portions divided in the manner in the above example. In a further embodiment, the second threshold are defined based on the distance from the second main surface 21b to the vehicle limit L0 at the center in the width direction and the distance from the second main surface 21b to the vehicle limit L0 at the end in the width direction. More specifically, the second threshold value is defined as the average of the distance from the second main surface 21b to the vehicle limit L0 at the center of the width direction and the distance from the second main surface 21b to the vehicle limit L0 at the end in the width direction.

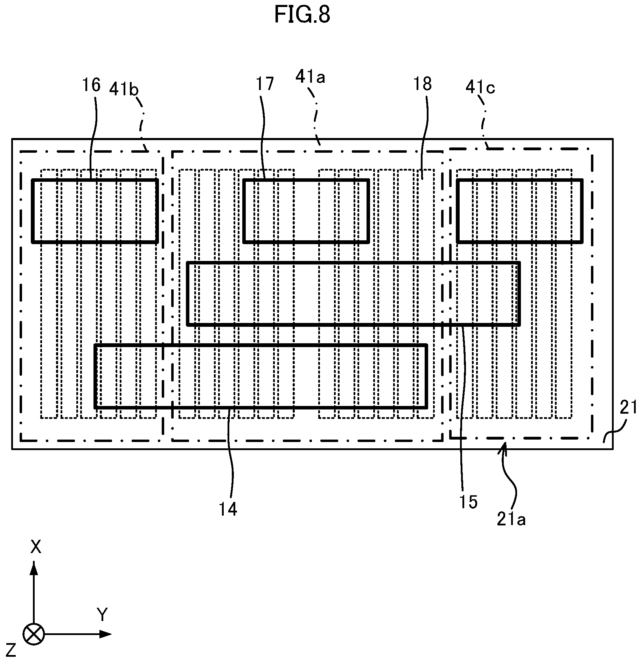

The electronic components 40 may be arranged in any manner other than described in the above example when the electronic components 40 mounted in the first central portion 41a corresponding to the second central portion 42a with the heat dissipation members 22 having higher cooling performance generate more heat than the electronic components 40 mounted in the first end portions 41b and 41c. In an example illustrated in FIG. 8, the U-phase circuit 16, the V-phase circuit 17, and the W-phase circuit 18 in the inverter 13 may be arranged in the Y-axis direction at the end of the first main surface 21a in the positive X-axis direction. The U-phase circuit 14 in the converter 12 is mounted on the first main surface 21a across the first end portion 41b and the first central portion 41a. The V-phase circuit 15 in the converter 12 is mounted on the first main surface 21a across the first central portion 41a and the first end portion 41c. Thus, more electronic components 40 may be mounted in the first central portion 41a than in the first end portions 41b and 41c to maximize the cooling performance of the heat dissipation members 22 to cool the electronic components 40.

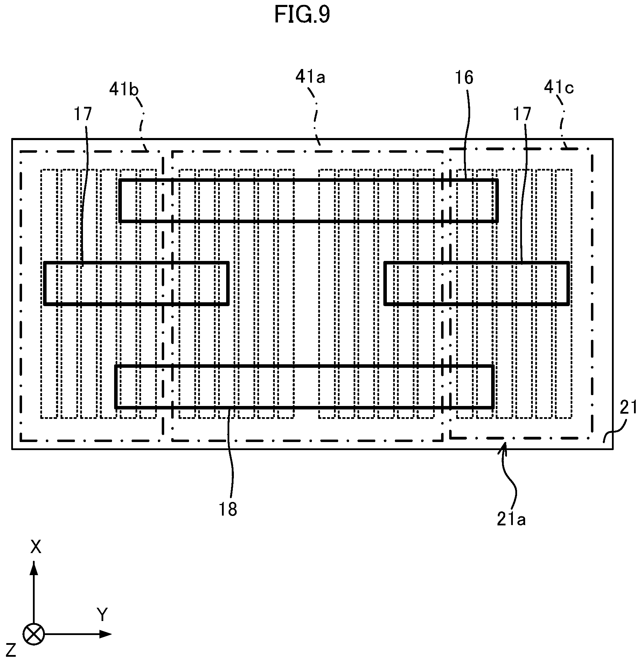

The circuit configuration of the electronic device 1 or 2 is not limited to the above examples and may be modified as appropriate. In an example, the electronic device 1 or 2 may include no converter 12 and simply include the capacitors C1 and C2 and the inverter 13. In this case, the electronic device 1 or 2 is a power converter that converts DC input power to three-phase AC power. As illustrated in FIG. 9, for example, the U-phase circuit 16 and the W-phase circuit 18 may be mounted at the center of the first main surface 21a in the Y-axis direction, and the V-phase circuit 17 may include multiple V-phase circuits 17 distributed at the ends of the first main surface 21a in the Y-axis direction.

In another example, the electronic device 1 or 2 may further include an inverter connected to the capacitors C1 and C2 in parallel with the inverter 13 to supply power to other loads. The inverter may supply power to, for example, loads such as an air conditioner, lighting equipment, and a door open-close device. The electronic components 40 in the inverter are mounted on the first main surface 21a in the same manner as the converter 12 and the inverter 13.

The circuit configuration of the converter 12 and the inverter 13 is not limited to the above example. Any number of switching elements SW1, SW2, SW3, SW4, and SW5 may be used.

The electronic device 1 or 2 may be installed in a recess on the roof 100a of the vehicle 100. In this case, the heat dissipation members 22 preferably have the vertically upper ends above the roof 100a in the vertical direction.

The housing 20 may be in any shape that can accommodate the electronic components 40 and can be attached to the roof 100a. In an example, the vertically upper surface of the housing 20 may be inclined with respect to the horizontal plane with the vehicle 100 located horizontally.

The base 21 may be a plate-like member with a curved surface protruding away from the housing 20. In this case, the heat dissipation members 22 may extend vertically upward with the vehicle 100 located horizontally.

The base 21 may be a single plate-like member as in the above embodiment, or may include multiple plate-like members joined together.

The electronic components mounted on the base 21 are not limited to the switching elements SW1, SW2, SW3, SW4, and SW5 and the diodes D1, D2, D3, D4, and D5, but may be any electronic components in the electronic device 1 or 2, for example, a thyristor, a diode, and a resistor accommodated in the housing 20.

The first heat transfer members 23 and the second heat transfer members 25 may each have a circular or elongated circular cross section perpendicular to the direction in which the first and second heat transfer members 23 and 25 extend. The elongated circular shape is acquired by deforming a circle to narrow a part of the dimension, and includes an ellipse, a streamline shape, and an oval. The oval refers to an outline of perimeters of two circles with the same diameter connected with two straight lines.

The orientation of the fins 24 attached to the first heat transfer members 23 is not limited to the above example. In an example, the fins 24 may be attached to the first heat transfer members 23 with the main surfaces inclined with respect to the horizontal plane. The fins 24 inclined with respect to the second main surface 21b allow air heated with heat transferred from the fins 24 to move vertically upward along the fins 24 smoothly, thus improving the cooling performance.

Each fin 24 may be formed from the same material, or at least one fin 24 may be formed from a material different from the material of the other fins 24. When at least one fin 24 is formed from a material different from the material of the other fins 24, the fin 24 has thermal conductivity different from the thermal conductivity of the other fins 24. In an example, the fins 24 located in a vertically upper portion preferably have thermal conductivity higher than the thermal conductivity of the fins 24 located in a vertically lower portion. For example, the fins 24 located in the vertically upper portion may be formed from copper, and the fins 24 located in the vertically lower portion may be formed from aluminum.

In another example, the fins 24 attached to the first heat transfer members 23 attached to the second central portion 42a preferably have higher thermal conductivity than the fins 24 attached to the first heat transfer members 23 attached to the second end portions 42b and 42c.

Any number of fins 24 in any shape may be arranged in any manner other than in the above example. In an example, each fin 24 may be a plate-like member with a curved surface. In another example, each fin 24 may have a different shape. In another example, the multiple fins 24 may be arranged in the X-axis direction and the Y-axis direction. With the fins 24 arranged in the X-axis direction, air heated with heat transferred from the fins 24 flows vertically between the fins 24 adjacent to one another in the X-axis direction when the vehicle 100 is stopped. Thus, the electronic device 1 or 2 has higher natural cooling performance.

The second heat transfer members 25 may be partially received in a groove on the second main surface 21b of the base 21 and attached to the second main surface 21b in a manner partially exposed. In this case, each first heat transfer member 23 may be attached to the corresponding second heat transfer member 25 with an attaching method such as welding, or brazing and attached to the second main surface 21b through the second heat transfer member 25.

The electronic device 1 or 2 may further include a heat transfer member extending in the Y-axis direction and is embedded in the base 21. This structure diffuses heat in the base 21 in the Y-axis direction as well as in the X-axis direction and then transfers the heat to the first heat transfer members 23.

The cover 30 may be in any shape that covers the heat dissipation members 22 and allows air to flow inside. In an example, the cover 30 may have a vertically upper surface that is curved. In another example, the cover 30 may have a vertically upper surface that is flat. The cover 30 preferably has a shape that maximizes the internal space below the vehicle limit.

When other devices are located around the electronic device 1 or 2, the fins 24 located in the vertically upper portion can come in contact with air flowing from outside more easily than the fins 24 located in the vertically lower portion. Similarly, a vertically upper portion of each fin 24 can come in contact with air flowing from outside more easily than a vertically lower portion of each fin 24. For example, when the fins 24 located in the vertically upper portion have higher thermal conductivity and the fins 24 with the vertically upper ends located higher than the vertically upper ends of the other fins 24 have higher thermal conductivity, the electronic device 1 or 2 can have higher cooling performance.

The electronic device 1 or 2 may be installable on a DC feeding railway vehicle, rather than on an AC feeding railway vehicle. The electronic device 1 or 2 may be installable on any movable body that creates passing air, such as a trolley bus or a streetcar, rather than the railway vehicle.

### Reference Signs List

1, 2 Electronic device
1a, 1b Input terminal
11 Transformer
12 Converter
13 Inverter
14, 16U-phase circuit
15, 17 V-phase circuit
18 W-phase circuit
20 Housing
20a Opening
21 Base
21a First main surface
21b Second main surface
22 Heat dissipation member
23 First heat transfer member
24, 26 Fin
25 Second heat transfer member
30 Cover
30a, 30b Vent
40 Electronic component
41a First central portion
41b, 41c First end portion
42a Second central portion
42b, 42c Second end portion
61 Electric motor
100 Vehicle
100a Roof
C1, C2 Capacitor
D1, D2, D3, D4, D5 Diode
L0 Vehicle limit
L1, L2, L3 Distance
SW1, SW2, SW3, SW4, SW5 Switching element

## Claims

1. An electronic device (1, 2), comprising:
a housing (20) configured to be installed on a roof (100a) of a vehicle (100), the housing (20) having an opening (20a) in a vertically upper portion of the housing (20) and accommodating a plurality of electronic components (40) that generate heat when energized;
a base (21) being heat-transferable, the base (21) having a first main surface (21a) on which the plurality of electronic components (40) are mounted, the base (21) being attached to the housing (20) with the first main surface (21a) covering the opening (20a) in the housing (20); and
a plurality of heat dissipation members (22) attached to a second main surface (21b) of the base (21) opposite to the first main surface (21a) to dissipate, into ambient air, heat transferred from the plurality of electronic components (40) through the base (21); wherein
the plurality of heat dissipation members (22) include a plurality of first heat transfer members (23) extending away from the second main surface (21b) and a plurality of fins (24) attached to the plurality of first heat transfer members (23),
the plurality of electronic components (40) include electronic components (40) mounted in a first central portion (41a) of the first main surface (21a) and electronic components (40) mounted in first end portions (41b, 41c) of the first main surface (21a), the first central portion (41a) has a distance greater than or equal to a first threshold to a vehicle limit (L0) on the roof (100a) of the vehicle (100), the first end portions (41b, 41c) are located with the first central portion (41a) between the first end portions (41b, 41c) in a width direction of the vehicle (100) and have a distance less than the first threshold to the vehicle limit (L0), and
the plurality of first heat transfer members (23) and the plurality of fins (24) attached to the plurality of first heat transfer members (23) include first heat transfer members (23) and fins (24) attached to a second central portion (42a) of the second main surface (21b) and first heat transfer members (23) and fins (24) attached to second end portions (42b, 42c) of the second main surface (21b), the second central portion (42a) has a distance greater than or equal to a second threshold to the vehicle limit (L0), the second end portions (42b, 42c) are located with the second central portion (42a) between the second end portions (42b, 42c) in the width direction and have a distance less than the second threshold to the vehicle limit (L0), and the first heat transfer members (23) and fins (24) attached to the second central portion (42a) have a larger total surface area than the first heat transfer members (23) and fins (24) attached to the second end portions (42b, 42c),
wherein:
the first threshold is the distance from the first main surface (21a) to the vehicle limit (L0) at a position shifted from the end of the first main surface (21a) toward the center of the base (21) in the width direction of the vehicle (100) by one-fourth of the length of the base (21) in the width direction, and the second threshold is the distance from the second main surface (21b) to the vehicle limit (L0) at a position shifted from the end of the second main surface (21b) toward the center of the base (21) in the width direction of the vehicle (100) by one-fourth of the length of the base (21) in the width direction; or
the first threshold is defined as the average of the distance from the first main surface (21a) to the vehicle limit (L0) at the center in the width direction and the distance from the first main surface (21a) to the vehicle limit (L0) at the end in the width direction, and the second threshold value is defined as the average of the distance from the second main surface (21b) to the vehicle limit (L0) at the center in the width direction and the distance from the second main surface (21b) to the vehicle limit (L0) at the end in the width direction,
**characterized in that**
the electronic components (40) in the first central portion (41a) have a greater amount of total heat generation than the electronic components (40) in the first end portions (41b, 41c),
the plurality of electronic components (40) include a plurality of first electronic components and a plurality of second electronic components, and the plurality of second electronic components generate more heat at a time different from a time at which each of the plurality of first electronic components generates more heat,
the plurality of first electronic components and the plurality of second electronic components are mounted on the base (21) at positions adjacent to each other in a travel direction of the vehicle (100),
the plurality of first electronic components include a plurality of switching elements included in a converter (12) to convert supplied alternating current power to direct current power and output the direct current power,
the plurality of second electronic components include a plurality of switching elements included in an inverter (13) to convert the direct current power output by the converter (12) to alternating current power and output the alternating current power,
at least two of the plurality of first electronic components are mounted in the first central portion (41a) at positions to have a second electronic component of the plurality of second electronic components between the at least two of the plurality of first electronic components in the travel direction of the vehicle (100), and
another of the plurality of first electronic components is mounted in a first end portion of the first end portions (41b, 41c) at a position adjacent to a second electronic component of the plurality of second electronic components in the travel direction of the vehicle (100).

2. The electronic device (1, 2) according to claim 1, wherein
the plurality of heat dissipation members (22) include the plurality of first heat transfer members (23) attached to the second main surface (21b) and extending away from the second main surface (21b) to transfer heat away from the second main surface (21b), and the plurality of fins (24) attached to the plurality of first heat transfer members (23) with main surfaces of the plurality of fins (24) extending along the second main surface (21b), and
the plurality of first heat transfer members (23) include first heat transfer members (23) attached to the second central portion (42a) and first heat transfer members (23) attached to the second end portions (42b, 42c), and the first heat transfer members (23) attached to the second central portion (42a) are longer than the first heat transfer members (23) attached to the second end portions (42b, 42c) in a direction in which the plurality of first heat transfer members (23) extend.

3. The electronic device (1, 2) according to claim 2, wherein
the plurality of fins (24) include more fins (24) attached to the first heat transfer members (23) attached to the second central portion (42a) than to the first heat transfer members (23) attached to the second end portions (42b, 42c).

4. The electronic device (1, 2) according to claim 1, wherein
the plurality of heat dissipation members (22) include a plurality of fins (26), and the plurality of fins (26) are attached to the second main surface (21b) with main surfaces of the plurality of fins (26) extending along a travel direction of the vehicle (100) and arranged in the width direction, and
the plurality of fins (26) include fins (26) attached to the second central portion (42a) and fins (26) attached to the second end portions (42b, 42c), and the fins (26) attached to the second central portion (42a) have a larger total surface area than the fins (26) attached to the second end portions (42b, 42c).

5. The electronic device (1, 2) according to any one of claims 1 to 4, wherein
a number of the electronic components (40) mounted in the first central portion (41a) is greater than a number of the electronic components (40) mounted in the first end portions (41b, 41c).

6. The electronic device (1, 2) according to any one of claims 1 to 5, wherein
the first central portion (41a) has an area substantially equal to a total area of the first end portions (41b, 41c).

7. The electronic device (1, 2) according to any one of claims 1 to 6, wherein
the second central portion (42a) has an area substantially equal to a total area of the second end portions (42b, 42c).

## Patentansprüche

1. Elektronische Vorrichtung (1, 2), die aufweist:
ein Gehäuse (20), das eingerichtet ist, auf einem Dach (100a) eines Fahrzeugs (100) installiert zu werden, wobei das Gehäuse (20) eine Öffnung (20a) in einem vertikal oberen Bereich des Gehäuses (20) aufweist und eine Vielzahl von elektronischen Komponenten (40) aufnimmt, die unter Energiezufuhr Wärme erzeugen;
eine Basis (21), die Wärme übertragen kann, wobei die Basis (21) eine erste Hauptfläche (21a) aufweist, auf der die Vielzahl von elektronischen Komponenten (40) montiert ist, wobei die Basis (21) an dem Gehäuse (20) angebracht ist, wobei die erste Hauptfläche (21a) die Öffnung (20a) im Gehäuse (20) bedeckt; und
eine Vielzahl von Wärmeableitgliedern (22), die an einer zweiten Hauptfläche (21b) der Basis (21) gegenüberliegend zu der ersten Hauptfläche angebracht sind, um die von der Vielzahl von elektronischen Komponenten (40) übertragene Wärme über die Basis (21) an Umgebungsluft abzuleiten; wobei
die Vielzahl von Wärmeableitgliedern (22) eine Vielzahl von ersten Wärmeübertragungsgliedern (23), die sich von der zweiten Hauptfläche (21b) weg erstrecken, und eine Vielzahl von Rippen (24) umfasst, die an der Vielzahl von ersten Wärmeübertragungsgliedern (23) angebracht sind,
die Vielzahl von elektronischen Komponenten (40) elektronische Komponenten (40), die in einem ersten Zentralabschnitt (41a) der ersten Hauptfläche (21a) montiert sind und elektronische Komponenten (40), die in ersten Endabschnitten (41b, 41c) der ersten Hauptfläche (21a) montiert sind, umfasst, wobei der erste Zentralabschnitt (41a) einen Abstand zu einer Fahrzeugbegrenzung (L0) auf dem Dach (100a) des Fahrzeugs (100) aufweist, der größer oder gleich einem ersten Schwellenwert ist, wobei die ersten Endabschnitte (41b, 41c) derart lokalisiert sind, dass der erste Zentralabschnitt (41a) zwischen den ersten Endabschnitten (41b, 41c) in einer Querrichtung des Fahrzeugs (100) lokalisiert ist, und einen Abstand zu der Fahrzeugbegrenzung (L0) aufweisen, der kleiner als der erste Schwellenwert ist, und
die Vielzahl von ersten Wärmeübertragungsgliedern (23) und die Vielzahl von Rippen (24), die an der Vielzahl von ersten Wärmeübertragungsgliedern angebracht sind, erste Wärmeübertragungsglieder (23) und Rippen (24), die an einem zweiten Zentralabschnitt (42a) der zweiten Hauptfläche (21b) angebracht sind, und erste Wärmeübertragungsglieder (23) und Rippen (24), die an zweiten Endabschnitten (42b, 42c) der zweiten Hauptfläche (21b) angebracht sind, umfassen, wobei der zweite Zentralabschnitt (42a) einen Abstand zu der Fahrzeugbegrenzung (L0) aufweist, der größer oder gleich einem zweiten Schwellenwert ist, wobei die zweiten Endabschnitte (42b, 42c) derart lokalisiert sind, dass der zweite Zentralabschnitt (42a) zwischen den zweiten Endabschnitten (42b, 42c) in der Querrichtung lokalisiert ist, und einen Abstand zu der Fahrzeugbegrenzung (L0) aufweisen, der kleiner als der zweite Schwellenwert ist, und wobei die ersten Wärmeübertragungsglieder (23) und Rippen (24), die in dem zweiten Zentralabschnitt (42a) angebracht sind, eine größere Gesamtfläche als die ersten Wärmeübertragungsglieder (23) und Rippen (24) aufweisen, die an den zweiten Endabschnitten (42b, 42c) angebracht sind,
wobei:
der erste Schwellenwert der Abstand von der ersten Hauptfläche (21a) zu der Fahrzeugbegrenzung (L0) in einer Position ist, die von dem Ende der ersten Hauptfläche (21a) um ein Viertel der Länge der Basis (21) hin zu dem Zentrum der Basis (21) in der Querrichtung des Fahrzeugs (100) versetzt ist, und der zweite Schwellenwert der Abstand von der zweiten Hauptfläche (21b) zu der Fahrzeugbegrenzung (L0) in einer Position ist, die von dem Ende der zweiten Hauptfläche (21b) hin zu dem Zentrum der Basis (21) in der Querrichtung des Fahrzeugs (100) um ein Viertel der Länge der Basis (21) versetzt ist; oder
der erste Schwellenwert als der Durchschnitt des Abstands von der ersten Hauptfläche (21a) zu der Fahrzeugbegrenzung (L0) in dem Zentrum in der Querrichtung und des Abstands von der ersten Hauptfläche (21a) zu der Fahrzeugbegrenzung (L0) am Ende in der Querrichtung definiert ist, und der zweite Schwellenwert als der Durchschnitt des Abstands von der zweiten Hauptfläche (21b) zu der Fahrzeugbegrenzung (L0) in dem Zentrum in der Querrichtung und des Abstands von der zweiten Hauptfläche (21b) zu der Fahrzeugbegrenzung (L0) am Ende in Querrichtung definiert ist,
**dadurch gekennzeichnet, dass**
die elektronischen Komponenten (40) in dem ersten Zentralabschnitt (41a) eine größere Menge einer Gesamtwärmeerzeugung als die elektronischen Komponenten (40) in den ersten Endabschnitten (41b, 41c) aufweisen,
die Vielzahl von elektronischen Komponenten (40) eine Vielzahl von ersten elektronischen Komponenten und eine Vielzahl von zweiten elektronischen Komponenten umfasst, und die Vielzahl von zweiten elektronischen Komponenten zu einem Zeitpunkt mehr Wärme erzeugt und zu einem anderen Zeitpunkt jede aus der Vielzahl von ersten elektronischen Komponenten mehr Wärme erzeugt,
die Vielzahl von ersten elektronischen Komponenten und die Vielzahl von zweiten elektronischen Komponenten auf der Basis (21) in Positionen montiert sind, die in einer Fahrtrichtung des Fahrzeugs (100) aneinandergrenzen,
die Vielzahl von ersten elektronischen Komponenten eine Vielzahl von Schaltelementen umfasst, die in einem Wandler (12) angeordnet sind, um eine zugeführte Wechselstromleistung in eine Gleichstromleistung zu wandeln und die Gleichstromleistung auszugeben,
die Vielzahl von zweiten elektronischen Komponenten eine Vielzahl von Schaltelementen umfasst, die von einem Wechselrichter (13) umfasst sind, um die Gleichstromleistung, die durch den Wandler (12) ausgegeben wird, in eine Wechselstromleistung umzuwandeln und die Wechselstromleistung auszugeben,
mindestens zwei von der Vielzahl von ersten elektronischen Komponenten in dem ersten Zentralabschnitt (41a) in Positionen montiert sind, sodass sich eine zweite elektronische Komponente aus der Vielzahl von zweiten elektronischen Komponenten zwischen mindestens zwei aus der Vielzahl von ersten elektronischen Komponenten in der Fahrtrichtung des Fahrzeugs (100) befindet, und
eine weitere aus der Vielzahl von ersten elektronischen Komponenten in einem ersten Endabschnitt der ersten Endabschnitte (41b, 41c) in einer Position montiert ist, die in der Fahrtrichtung des Fahrzeugs (100) an eine zweite elektronische Komponente aus der Vielzahl von zweiten elektronischen Komponenten angrenzt.

2. Elektronische Vorrichtung (1, 2) nach Anspruch 1, wobei
die Vielzahl von Wärmeableitgliedern (22) die Vielzahl von ersten Wärmeübertragungsgliedern (23), die an der zweiten Hauptfläche (21b) angebracht sind, und sich von der zweiten Hauptfläche (21b) weg erstrecken, um Wärme von der zweiten Hauptfläche (21b) wegzuleiten, und die Vielzahl von Rippen (24) umfasst, die an der Vielzahl von ersten Wärmeübertragungsgliedern (23) angebracht sind, wobei sich Hauptflächen von der Vielzahl von Rippen (24) entlang der zweiten Hauptfläche (21b) erstrecken, und
die Vielzahl von ersten Wärmeübertragungsgliedern (23) erste Wärmeübertragungsglieder (23), die an dem zweiten Zentralabschnitt (42a) angebracht sind, und erste Wärmeübertragungsglieder (23), die an den zweiten Endabschnitten (42b, 42c) angebracht sind, umfasst, und wobei die ersten Wärmeübertragungsglieder (23), die an dem zweiten Zentralabschnitt (42a) angebracht sind, eine größere Länge in einer Richtung, in der sich die Vielzahl von ersten Wärmeübertragungsgliedern (23) erstreckt, aufweisen als die ersten Wärmeübertragungsglieder (23), die an den zweiten Endabschnitten (42b, 42c) angebracht sind.

3. Elektronische Vorrichtung (1, 2) nach Anspruch 2, wobei
die Vielzahl von Rippen (24) mehr Rippen (24), die an den ersten Wärmeübertragungsgliedern (23) angebracht sind, die an dem zweiten Zentralabschnitt (42a) angebracht sind, als an den ersten Wärmeübertragungsgliedern (23), die an den zweiten Endabschnitten (42b, 42c) angebracht sind, umfasst.

4. Elektronische Vorrichtung (1, 2) nach Anspruch 1, wobei
die Vielzahl von Wärmeableitgliedern (22) eine Vielzahl von Rippen (26) umfasst, und die Vielzahl von Rippen (26) an der zweiten Hauptfläche (21b) angebracht sind, wobei sich Hauptflächen von der Vielzahl von Rippen (26) entlang der Fahrtrichtung des Fahrzeugs (100) erstrecken und in der Querrichtung angeordnet sind, und
die Vielzahl von Rippen (26) Rippen (26), die an dem zweiten Zentralabschnitt (42a) angebracht sind und Rippen (26), die an den zweiten Endabschnitten (42b, 42c) angebracht sind, umfasst, wobei die Rippen (26), die an dem zweiten Zentralabschnitt (42a) angebracht sind, eine größere Gesamtfläche als die Rippen (26), die an den zweiten Endabschnitten (42b, 42c) angebracht sind, aufweisen.

5. Elektronische Vorrichtung (1, 2) nach einem der Ansprüche 1 bis 4, wobei
eine Anzahl der elektronischen Komponenten (40), die in dem ersten Zentralabschnitt (41a) montiert sind, größer als eine Anzahl der elektronischen Komponenten (40) ist, die in den ersten Endabschnitten (41b, 41c) montiert sind.

6. Elektronische Vorrichtung (1, 2) nach einem der Ansprüche 1 bis 5, wobei
der erste Zentralabschnitt (41a) eine Fläche aufweist, die im Wesentlichen der Gesamtfläche der ersten Endabschnitte (41b, 41c) entspricht.

7. Elektronische Vorrichtung (1, 2) nach einem der Ansprüche 1 bis 6, wobei
der zweite Zentralabschnitt (42a) eine Fläche aufweist, die im Wesentlichen der Gesamtfläche der zweiten Endabschnitte (42b, 42c) entspricht.

## Revendications

1. Dispositif électronique (1, 2), comprenant :
un boîtier (20) conçu pour être installé sur un toit (100a) d'un véhicule (100), le boîtier (20) ayant une ouverture (20a) dans une partie verticalement supérieure du boîtier (20) et logeant une pluralité de composants électroniques (40) qui génèrent de la chaleur lorsqu'ils sont excités ;
une base (21) qui est thermotransférable, la base (21) ayant une première surface principale (21a) sur laquelle la pluralité de composants électroniques (40) sont montés, la base (21) étant fixée au boîtier (20) avec la première surface principale (21a) couvrant l'ouverture (20a) dans le boîtier (20) ; et
une pluralité d'éléments de dissipation de chaleur (22) fixés à une seconde surface principale (21b) de la base (21) opposée à la première surface principale (21a) pour dissiper, dans l'air ambiant, de la chaleur transférée depuis la pluralité de composants électroniques (40) à travers la base (21) ; dans lequel
la pluralité d'éléments de dissipation de chaleur (22) comportent une pluralité de premiers éléments de transfert de chaleur (23) s'étendant à l'écart de la seconde surface principale (21b) et une pluralité d'ailettes (24) fixées à la pluralité de premiers éléments de transfert de chaleur (23),
la pluralité de composants électroniques (40) comportent des composants électroniques (40) montés dans une première partie centrale (41a) de la première surface principale (21a) et des composants électroniques (40) montée dans des premières parties d'extrémité (41b, 41c) de la première surface principale (21a), la première partie centrale (41a) a une distance supérieure ou égale à un premier seuil par rapport à une limite de véhicule (L0) sur le toit (100a) du véhicule (100), les premières parties d'extrémité (41b, 41c) sont situées avec la première partie centrale (41a) entre les premières parties d'extrémité (41b, 41c) dans une direction de la largeur du véhicule (100) et ont une distance inférieure au premier seuil par rapport à la limite de véhicule (L0), et
la pluralité de premiers éléments de transfert de chaleur (23) et la pluralité d'ailettes (24) fixées à la pluralité de premiers éléments de transfert de chaleur (23) comportent des premiers éléments de transfert de chaleur (23) et des ailettes (24) fixés à une seconde partie centrale (42a) de la seconde surface principale (21b) et des premiers éléments de transfert de chaleur (23) et des ailettes (24) fixés à des secondes parties d'extrémité (42b, 42c) de la seconde surface principale (21b), la seconde partie centrale (42a) a une distance supérieure ou égale à un second seuil par rapport à la limite de véhicule (L0), les secondes parties d'extrémité (42b, 42c) sont situées avec la seconde partie centrale (42a) entre les secondes parties d'extrémité (42b, 42c) dans la direction de la largeur et ont une distance inférieure au second seuil de la limite de véhicule (L0), et les premiers éléments de transfert de chaleur (23) et les ailettes (24) fixés à la seconde partie centrale (42a) ont une aire de surface totale plus grande que les premiers éléments de transfert de chaleur (23) et les ailettes (24) fixés aux secondes parties d'extrémité (42b, 42c),
dans lequel :
le premier seuil est la distance allant de la première surface principale (21a) jusqu'à la limite de véhicule (L0) au niveau d'une position décalée depuis l'extrémité de la première surface principale (21a) vers le centre de la base (21) dans la direction de la largeur du véhicule (100) d'un quart de la longueur de la base (21) dans la direction de la largeur, et le second seuil est la distance allant de la seconde surface principale (21b) jusqu'à la limite de véhicule (L0) au niveau d'une position décalée depuis l'extrémité de la seconde surface principale (21b) vers le centre de la base (21) dans la direction de la largeur du véhicule (100) d'un quart de la longueur de la base (21) dans la direction de la largeur ; ou
le premier seuil est défini comme la moyenne de la distance allant de la première surface principale (21a) jusqu'à la limite de véhicule (L0) au niveau du centre dans la direction de la largeur et de la distance allant de la première surface principale (21a) jusqu'à la limite de véhicule (L0) au niveau de l'extrémité dans la direction de la largeur, et la deuxième valeur seuil est définie comme la moyenne de la distance allant de la seconde surface principale (21b) jusqu'à la limite de véhicule (L0) au niveau du centre dans la direction de la largeur et de la distance allant de la seconde surface principale (21b) jusqu'à la limite de véhicule (L0) au niveau de l'extrémité dans la direction de la largeur,
**caractérisé en ce que**
les composants électroniques (40) dans la première partie centrale (41a) ont une quantité supérieure de génération totale de chaleur que les composants électroniques (40) dans les premières parties d'extrémité (41b, 41c),
la pluralité de composants électroniques (40) comportent une pluralité de premiers composants électroniques et une pluralité de seconds composants électroniques, et la pluralité de seconds composants électroniques génèrent plus de chaleur à un moment différent d'un moment auquel chacun de la pluralité de premiers composants électroniques génère plus de chaleur,
la pluralité de premiers composants électroniques et la pluralité de seconds composants électroniques sont montés sur la base (21) au niveau de positions adjacentes les unes aux autres dans une direction de déplacement du véhicule (100),
la pluralité de premiers composants électroniques comportent une pluralité d'éléments de commutation inclus dans un convertisseur (12) pour convertir de la puissance en courant alternatif fournie en puissance en courant continu et délivrer en sortie la puissance en courant continu,
la pluralité de seconds composants électroniques comportent une pluralité d'éléments de commutation inclus dans un onduleur (13) pour convertir la puissance en courant continu délivrée en sortie par le convertisseur (12) en puissance en courant alternatif et délivrer en sortie la puissance en courant alternatif,
au moins deux de la pluralité de premiers composants électroniques sont montés dans la première partie centrale (41a) au niveau de positions pour avoir un second composant électronique de la pluralité de seconds composants électroniques entre les au moins deux de la pluralité de premiers composants électroniques dans la direction de déplacement du véhicule (100), et
un autre de la pluralité de premiers composants électroniques est monté dans une première partie d'extrémité des premières parties d'extrémité (41b, 41c) au niveau d'une position adjacente à un second composant électronique de la pluralité de seconds composants électroniques dans la direction de déplacement du véhicule (100).

2. Dispositif électronique (1, 2) selon la revendication 1, dans lequel
la pluralité d'éléments de dissipation de chaleur (22) comportent la pluralité de premiers éléments de transfert de chaleur (23) fixés à la seconde surface principale (21b) et s'étendant à l'écart de la seconde surface principale (21b) pour transférer de la chaleur à l'écart de la seconde surface principale (21b), et la pluralité d'ailettes (24) fixées à la pluralité de premiers éléments de transfert de chaleur (23) avec des surfaces principales de la pluralité d'ailettes (24) s'étendant le long de la seconde surface principale (21b), et
la pluralité de premiers éléments de transfert de chaleur (23) comportent des premiers éléments de transfert de chaleur (23) fixés à la seconde partie centrale (42a) et des premiers éléments de transfert de chaleur (23) fixés aux secondes parties d'extrémité (42b, 42c), et les premiers éléments de transfert de chaleur (23) fixés à la seconde partie centrale (42a) sont plus longs que les premiers éléments de transfert de chaleur (23) fixés aux secondes parties d'extrémité (42b, 42c) dans une direction dans laquelle la pluralité de premiers éléments de transfert de chaleur (23) s'étendent.

3. Dispositif électronique (1, 2) selon la revendication 2, dans lequel
la pluralité d'ailettes (24) comportent plus d'ailettes (24) fixées aux premiers éléments de transfert de chaleur (23) fixés à la seconde partie centrale (42a) qu'aux premiers éléments de transfert de chaleur (23) fixés aux secondes parties d'extrémité (42b, 42c).

4. Dispositif électronique (1, 2) selon la revendication 1, dans lequel
la pluralité d'éléments de dissipation de chaleur (22) comportent une pluralité d'ailettes (26), et la pluralité d'ailettes (26) sont fixées à la seconde surface principale (21b) avec des surfaces principales de la pluralité d'ailettes (26) s'étendant le long d'une direction de déplacement du véhicule (100) et agencées dans la direction de la largeur, et
la pluralité d'ailettes (26) comportent des ailettes (26) fixées à la seconde partie centrale (42a) et des ailettes (26) fixées aux secondes parties d'extrémité (42b, 42c), et les ailettes (26) fixées à la seconde partie centrale (42a) ont une aire de surface totale plus grande que les ailettes (26) fixées aux secondes parties d'extrémité (42b, 42c).

5. Dispositif électronique (1, 2) selon l'une quelconque des revendications 1 à 4, dans lequel
un nombre de composants électroniques (40) montés dans la première partie centrale (41a) est supérieur à un nombre des composants électroniques (40) montés dans les premières parties d'extrémité (41b, 41c).

6. Dispositif électronique (1, 2) selon l'une quelconque des revendications 1 à 5, dans lequel
la première partie centrale (41a) a une aire sensiblement égale à une aire totale des premières parties d'extrémité (41b, 41c).

7. Dispositif électronique (1, 2) selon l'une quelconque des revendications 1 à 6, dans lequel
la seconde partie centrale (42a) a une aire sensiblement égale à une aire totale des secondes parties d'extrémité (42b, 42c).
